Europäisches Patentamt

European Patent Office

Office européen des brevets

(11) Publication number: 0 179 294
A1

# EUROPEAN PATENT APPLICATION

(21) Application number: 85112117.8

(22) Date of filing: 25.09.85

(51) Int. Cl.⁴: **H01J 37/317** , H01J 37/147

(30) Priority: 27.09.84 JP 200424/84

(43) Date of publication of application:
30.04.86 Bulletin 86/18

(84) Designated Contracting States:
DE FR GB

(71) Applicant: HITACHI, LTD.
6, Kanda Surugadai 4-chome Chiyoda-ku
Tokyo 100(JP)

(72) Inventor: Kawanami, Yoshimi
4-1-2, Hiyoshi-cho
Kokubunji-shi Tokyo(JP)
Inventor: Ishitani, Tohru
1354-56, Irumagawa
Sayama-shi Saitama-ken(JP)
Inventor: Umemura, Kaoru
4-14-6, Nishikoigakubo
Kokubunji-shi Tokyo(JP)
Inventor: Tamura, Hifumi
10-8, Kiyokawa-cho
Hachioji-shi Tokyo(JP)

(74) Representative: Strehl, Schübel-Hopf, Schulz
Widenmayerstrasse 17 Postfach 22 03 45
D-8000 München 22(DE)

(54) Ion microbeam apparatus.

(57) An ion microbeam apparatus is disclosed which comprises an ion source (1), a beam convergence system (3a, 3b, 5, 6a, 6b, 20) for accelerating, converging and deflecting the ions emitted from the ion source (1) and a sample table (4) supporting thereon a sample (4a). In order easily to change the diameter of the ion beam radiated to the sample (4a), a beam control unit (20) is disposed in the beam convergence system, the beam control unit (20) comprising beam diameter contraction beams (7), a pre-stage deflection plate (13a, 13b) disposed at a pre-stage of the beam diameter contraction means (7) and deflecting the ion beam so that it passes through a predetermined position of the beam diameter contraction means (7), and a post-stage deflection plate (14a, 14b) disposed at the post-stage of the beam diameter contraction means (7) and returns the ion beam, that has passed through the beam diameter contraction means (7), to the original beam optical axis (10).

*FIG. 1*

# ION MICROBEAM APPARATUS

## BACKGROUND OF THE INVENTION

This invention relates generally to an ion microbeam apparatus. More particularly, the present invention relates to an improvement in ion microbeam apparatuses suitable for ion microbeam analysis, ion beam lithography, ion microimplantation, and so forth.

An ion microbeam apparatus radiates a narrow beam of ions, onto a sample, said beam having a diameter of up to about 1μm. An ion source having a point source and high brightness is used as the ion source. Examples of such ion sources include a liquid metal ion source, a field ionization ion source, a duoplasmatron ion source, and the like, as disclosed in the prior art reference "MASS-SEPARATED MICROBEAM SYSTEM WITH A LIQUID-METALION SOURCE" (T. ISHITANI et al, Nuclear Instruments and Methods in Physics Research 218(1983) 363-367), for example. An ion-optical system is so designed that the image of the ion-optical source can be formed on a sample.

The theoretical minimum diameter of the ion beam on the sample in an ion-optical system with no aberration is given by Md with d and M representing the size of the ion-optical source and the magnification of the ion-optical system, respectively. The minimum beam diameter in practice becomes greater than Md due to influences of the spherical aberration and chromatic aberration of the optical system. Since the spherical aberration and chromatic aberration depend upon the convergence angle of the ion beam at the focus, the practical minimum beam diameter D can be given approximately as follows with $\alpha$ representing the convergence half angle of the ion beam on the sample:

$$D^2 = (Md)^2 + (C_1\alpha)^2 + (C_2\alpha^3)^2$$

Here, $C_1$ is a coefficient related to the chromatic aberration, and $C_2$ is a coefficient related to the spherical aberration. Therefore, the beam diameter on the sample can be changed generally by changing the convergence angle of the ion beam on the sample by means of an aperture for determining beam diameter. To change the beam diameter on the sample, however, it has been customary practice in the art to mechanically shift one aperture plate having a plurality of apertures having varying sizes and to select the aperture for the radiation of the ion beam. Therefore, it has been necessary to align the aperture with an ion-optical axis, and since this is difficult, the beam diameter cannot be changed readily.

## SUMMARY OF THE INVENTION

The present invention is directed to provide an ion microbeam apparatus which can eliminate the disadvantages of the prior art technique described above, and can easily change the ion beam diameter on the sample.

In an ion microbeam apparatus including an ion source, a beam convergence system for accelerating, converging and deflecting the ion emitted from the ion source, and a sample table on which a sample is placed, the object of the present invention described above can be accomplished by an ion microbeam apparatus having a construction in which a beam diameter control unit is disposed in the beam convergence system, the beam diameter control unit comprising beam diameter contraction means for contracting variably the ion beam convergence angle on the sample table, pre-stage deflection plates disposed at a pre-stage of the beam diameter contraction means and deflecting the ion beam from the ion source so that it passes through a predetermined position of the beam diameter contraction means, and post-stage deflection plates disposed at a post-stage of the beam diameter contraction means and returning the ion beam, that has passed through the beam diameter contraction means, to the original beam-optical axis.

This construction makes it possible to arbitrarily change the apertures on the beam diameter contraction means through which the ion beam passes by setting voltages to be applied to the pre-stage and post-stage deflection plates to suitable levels, so that the ion beam diameter on the sample can be changed instant aneously in response to an electrical change.

## BRIEF DESCRIPTION OF THE DRAWINGS

Fig. 1 is a block diagram showing the construction of an ion microbeam apparatus in accordance with one embodiment of the present invention;

Fig. 2 is a block diagram showing the construction of a beam diameter control unit of an ion microbeam apparatus in accordance with another embodiment of the present invention;

Fig. 3 is a block diagram showing the construction of an ion microbeam apparatus in accordance with still another embodiment of the present invention; and

Fig. 4 is a perspective view showing a beam diameter control unit of the ion microbeam apparatus shown in Fig. 3.

## DESCRIPTION OF THE PREFERRED EMBODIMENTS

Hereinafter, some preferred embodiments of the present invention will be described in detail with reference to the accompanying drawings.

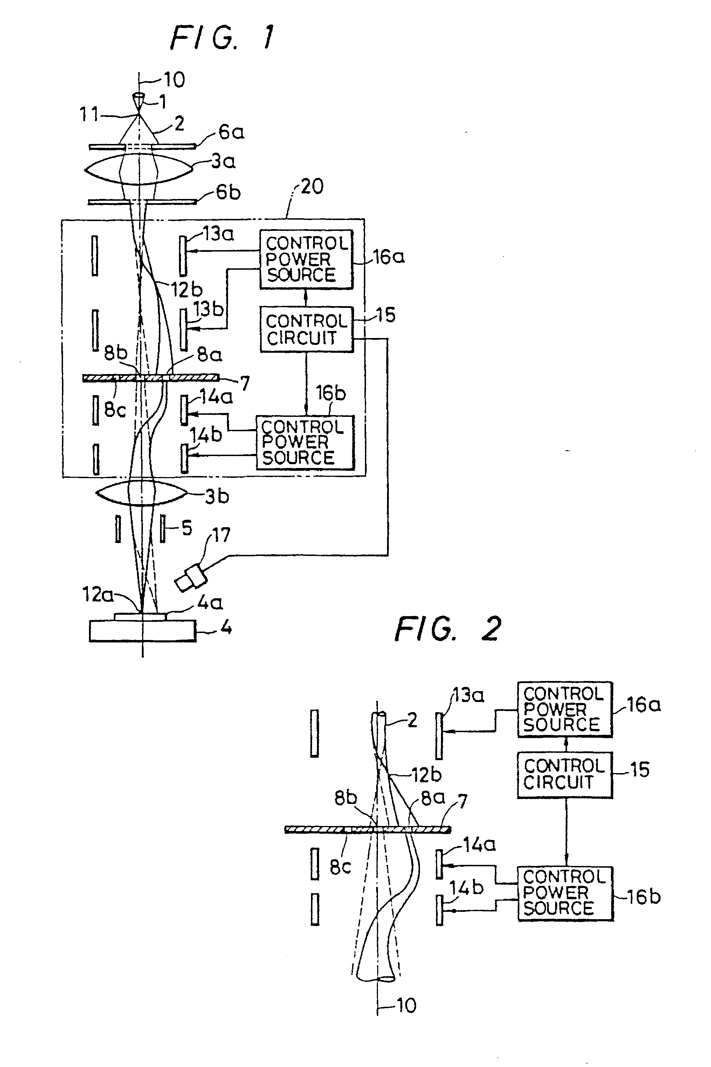

Fig. 1 shows the construction of a first embodiment of the present invention. An ion microbeam apparatus of this embodiment is used for focusing the image of an ion-optical source 11 on focal points 12a, 12b by use of two-stage electrostatic lenses 3a, 3b.

An ion beam 2 from an ion source 1 is contracted by aperture plates 6a and 6b, then passes through a beam diameter control unit 20 and is radiated on a sample 4a placed on a sample table 4. The position of the ion beam radiated on the sample 4a is controlled by a beam deflector 5.

When compared with conventional ion microbeam apparatuses, this embodiment is characterized in that it is equipped with the beam diameter control unit 20. Hereinafter, the beam diameter control unit of this embodiment will be explained. Each of the four-stage deflection plates 13a, 13b, 14a and 14b is one of four electrodes that constitute a quadrapole electrostatic deflector, and the deflection plates 13a and 13b have exactly the same shape while the deflection plates 14a and 14b have exactly the same shape. Voltages aplied to the deflection plates 13a and 13b by a control power source are asymmetric with respect to a plane passing through the center between these deflection plates 13a and 13b, and these plates together form an aligner. The relation between a control power source 16b and the deflection plates 14a, 14b is the same as above. The aligner is a device which emits an incident ion beam along another axis which is parallel to the axis of incidence. A plurality of apertures 8a, 8b, 8c having mutually different sizes are disposed on an aperture plate 7 that determines the convergence angle of the ion beam on the sample. Reference numeral 15 represents a control circuit, and reference numeral 17 represents a secondary electron detector.

In the construction described above, the beam diameter control unit 20 operates in the following manner. First of all, it shifts the ion beam parallel to its axis, that has passed through the apertures of the aperture plates 6a, 6b immediately after the ion source, from the ion optical axis 10 by means of the aligner formed by the deflection plates 13a, 13b, then selects a desired aperture 8 among the apertures 8a, 8b, 8c of the aperture plate 7 in the ion beam control unit, and vertically radiates the ion beam onto the aperture plate 7. The aperture plate 6b contracts the expansion radius of the ion beam on the aperture plate 7 so that the radius is smaller than the gap between the apertures 8 and does not radiate simultaneously two apertures.

Next, the beam diameter control unit shifts the ion beam parallel to its axis, that has passed through the aperture 8 of the aperture plate 7, by means of the aligner formed by the deflection plates 14a, 14b and lets the ion beam be incident to the original ion-optical axis 10.

The operations described above make it possible to change the beam diameter at the focal point 12 on the sample 4a in accordance with the diameter of the selected aperture of the aperture plate 7. Therefore, the beam diameter at the focal point 12 on the sample 4a can be electrically changed in an instant by storing the voltages to be applied to the deflection plates 13a, 13b, 14a, 14b in the control circuit 15 for each of a plurality of apertures 8a, 8b, 8c of the aperture plate 7.

Here, an example of a method of aligning the ion-optical axis in the beam diameter control unit, which must be effected at the beginning, will be described. First of all, while the deflection plates 13a, 13b, 14a, 14b are not operated, the aperture plate 7 is removed from the ion-optical axis, and adjustment is made so that the ion-optical axis of the lens 3a is in agreement with that of the lens 3b. When it is not possible to mechanically bring the ion-optical axis of the lens 3a into agreement with that of the lens 3b, a voltage for alignment is applied to the aligner formed by the deflection plates 14a, 14b in order to correct any deviation of the ion-optical axis of the lenses 3a and 3b.

Thereafter, an arbitary voltage for deflection is applied to each deflection plates 14a, 14b while keeping its function as the aligner, and the ion beam is returned to the ion-optical axis only when it passes through a certain point on the plane on which the aperture plate 7 is to exist. Similarly, a voltage for deflection is applied to each deflection plate 13a, 13b while keeping its function as the aligner, and the ion beam is luster-scanned on the plane on which the aperture plate 7 is to exist. The voltage values applied to the deflection plates 13a, 14a, 14a, 14b when the ion beam is incident to the lens 3b through the ion-optical axis are stored in the control circuit 15. After this procedure is conducted for a plurality of deflection voltages to be applied to the deflection plates 14a, 14b, the voltage values stored in the control circuit 15 are calculated in an appropriate manner in order to determine the ratio of the deflection voltages to be applied to the deflection plates 13a, 13b, 14a, 14b, the voltages being necessary so that the ion beam is passed through an arbitrary point on the plane, on which the aperture plate 7 is to exist, and is incident to the optical axes of the lenses 3a and 3b.

Finally, the aperture plate 7 is placed into the ion-optical axis 10, and the deflection voltages are applied to the deflection plates 13a, 13b, 14a, 14b so that the ion beam passes through the optical axes of the lenses 3a and 3b and is luster-scanned on the aperture plate 7. The voltages applied to the deflection plates 13a, 13b, 14a, 14b when the ion beam is radiated to the aperture having a desired size are detected and stored in the control circuit 15.

It is possible to know to which aperture 8 of the aperture plate 7 the ion beam is radiated by detecting the quantity of the current of the ion beam that passes through that aperture and reaches the sample 4a, or by detecting the quantity of secondary electrons generated when the ion beam is radiated to the sample through the aperture.

In the embodiment described above, a quadrapole electrostatic deflector is used for the deflection plates 13a, 13b, 14a, 14b, but other multipole electrostatic deflectors may also be used. It is also possible to use an electrostatic deflector having a pair of plates provided that the apertures 8a, 8b, 8c on the aperture plate 7 can be very accurately aligned on a line in the direction of an electric field generated by the electrostatic deflector.

Fig. 2 shows a beam diameter control unit of another embodiment of the present invention. The fundamental construction of the ion-optical system is the same as that of the first embodiment shown in Fig. 1. In this embodiment, three-stage deflection plates 13a, 14a and 14b in the beam diameter control unit constitute the quadrapole electrostatic deflectors, respectively, and the deflection plate 13a deflects the ion beam and radiates it to a desired aperture among a plurality of apertures of the aperture plate 7. The ion beam passing through the desired aperture is then returned to the ion-optical axis 10 by the deflection plates 14a and 14b. The voltage values to be applied to the deflection plates 13a, 14a and 14b in order to radiate the ion beam for each of a plurality of apertures of the aperture plate 7 are stored in the control circuit 15, so that the ion beam diameter on the sample can be instantly changed in response to an electrical change. In this embodiment, since the deflection plate 13a for selecting the aperture for the ion beam radiation is only one stage, the ion beam is incident slantingly to the aperture plate 7, but the beam diameter control unit can be made compact as a whole by use of an arrangement which prevents the occurrence of astigmatism, such as by forming the apertures in an elliptic shape.

Although the foregoing embodiments mention the ion beam diameter on the sample, they do not mention the current density. However, if the apertures of the aperture plate 7 are selected so that the convergence half angle of the ion beam on the sample is within the range of the chromatic aberration, the beam diameter of the ion beam on the sample can be changed without changing the current density. In each of the embodiments described above, the electrostatic deflector is used as means for deflecting the ion beam, but the same effect can be obtained by use of a magnetic deflector. The same effect can also be obtained by disposing the beam diameter control unit at the pre-stage of the first stage lens or at the post-stage of the final stage lens without disposing it between the lenses of the two stages. The effect of the present invention remains unchanged even when a mass separator is added to the beam convergence system.

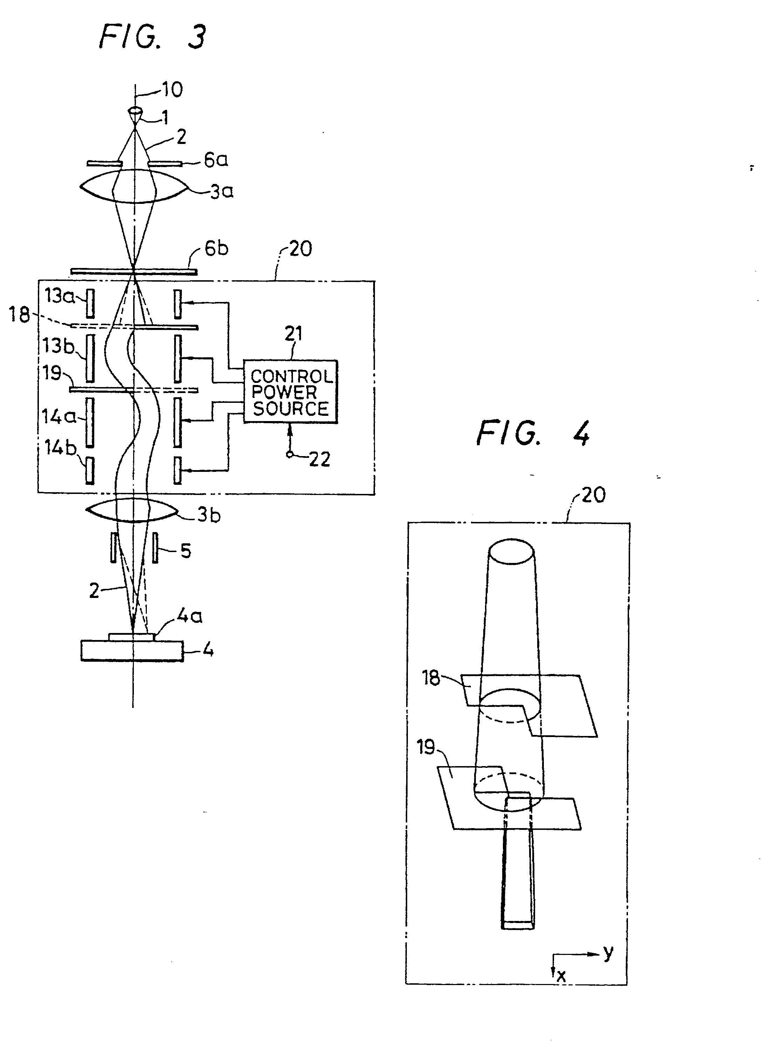

Fig. 3 is a block diagram showing still another embodiment of the present invention. This embodiment is the same as the foregoing embodiments in that the beam diameter control unit consisting of the beam diameter contraction means for variably contracting the ion beam convergence angle on the sample, the pre-stage deflection plates disposed at the pre-stage of the beam contraction means and deflecting the ion beam so that it passes through a desired position of the beam diameter contraction means and the post-stage deflection plates disposed at the post-stage and returning the ion beam to the original beamoptical axis, is disposed in the beam convergence system. However, this embodiment is different from the foregoing embodiments in the construction of the beam diameter contraction means in the beam diameter control unit. In other words, this embodiment is different from the foregoing embodiments in that is uses the beam diameter contraction means consisting of two aperture plates each having notches or apertures of a pre-determined shape and a deflection plate disposed between these two aperture plates and deflecting the passing ion beam.

The beam diameter control unit of the embodiment shown in Fig. 3 will now be explained.

Fig. 4 is a perspective view showing in detail the portion of the aperture plates. The beam diameter control unit 20 consists fundamentally of two aperture plates 18 and 19 for determining the beam diameter, four-stage quadrapole electrostatic deflection plates 13a, 13b, 14a, 14b and a control power source 21. Each of the two aperture plates 18, 19 is shaped, for example, by cutting off a quarter portion of a square plate. It forms a square beam having an arbitrary size by controlling the voltages to be applied to the deflection plate 13a disposed at the pre-stage of the aperture plate 18 and to the deflection plate 13b disposed between the two aperture plates 18 and 19. The deflection plates 14a and 14b return the square beam to the original beam optical axis. Beam control signals 22 in accordance with the intended beam shape are sent to the control power source 21, which generates the deflection voltages to be applied to the deflection plates 13a, 13b, 14a, 14b.

The embodiment shown in Fig. 3 can also change electrically the beam diameter on the sample 4a in an instant, and is extremely effective for shortening the microbeam radiation time. Particularly in the chromatic aberration range, the beam diameter can be changed while the current density is kept substantially constant. In the embodiment shown in Fig. 3, too, substantially the same effect can be obtained at whichever position of the beam convergence system the beam diameter control unit 20 is disposed. The same effect can be obtained when the ion beam passing through the beam diameter control units is either a parallel beam or a converged beam.

In the embodiment shown in Fig. 3, electrostatic type deflection plates 13a, 13b, 14a, 14b are used as the deflection plates, but they may be combined with, or replaced by, deflection plates of a magnetic type to obtain the same effect.

As described above, the present invention can select in an instant the sectional diameter or sectional shape of the ion beam passing through the aperture plate for determining the ion beam convergence angle, on the sample by the electric operation in the ion microbeam apparatus. Therefore, the present invention can easily change the ion beam diameter on the sample, can shorten the microbeam radiation time and can improve the efficiency of the ion microbeam apparatus.

## Claims

1. An ion microbeam apparatus equipped with an ion source (1), a beam convergence system (3a, 3b, 5, 6a, 6b, 20) for accelerating, converging and deflecting ions emitted from said ion source (1) and a sample table (4) on which a sample (4a) is placed, characterised in that a beam diameter control unit (20) is disposed in said ion beam convergence system, said beam diameter control unit (20) comprising beam diameter contraction means (7; 18, 19) for variably contracting the ion beam convergence angle on said sample table (4), pre-stage deflection plates (13a, 13b) disposed at a pre-stage of said beam diameter contraction means (7; 18, 19) and deflecting said ion beam from said ion source (1) so that it passes through a predetermined position of said beam diameter contraction means, and post-stage deflection plates (14a, 14b) disposed at a post-stage of said beam diameter contraction means (7; 18, 19) and returning said ion beam, that has passed through said beam diameter contraction means (7; 18, 19), to the original beam optical axis (10).

2. The apparatus of claim 1 wherein said beam diameter contraction means is an aperture plate (7) having a plurality of apertures (8a, 8b, 8c) of different sizes formed thereon.

3. The apparatus of claim 2 wherein said pre-stage deflection plates consist of a plurality of deflection plates (13a, 13b) which radiate said ion beam vertically to said aperture plate (7).

4. The apparatus of claim 2 wherein said pre-stage deflection plates consist of a single deflection plate (13a).

5. The apparatus of claim 1, wherein said beam diameter contraction means comprises two aperture plates (18, 19) each having notches or apertures of a predetermined shape, and a deflection plate (13b) disposed between said two aperture plates (18, 19) and deflecting and controlling said ion beam passing therethrough.

6. The apparatus of claim 5, wherein each of said aperture plates (18, 19) has a rectangular notch in such a manner as to generate a square ion beam.

# FIG. 1

CONTROL POWER SOURCE 16a

CONTROL CIRCUIT 15

CONTROL POWER SOURCE 16b

# FIG. 2

CONTROL POWER SOURCE 16a

CONTROL CIRCUIT 15

CONTROL POWER SOURCE 16b

# FIG. 3

CONTROL
POWER
SOURCE

# FIG. 4

## DOCUMENTS CONSIDERED TO BE RELEVANT

EP 85112117.8

| Category | Citation of document with indication, where appropriate, of relevant passages | Relevant to claim | CLASSIFICATION OF THE APPLICATION (Int. Cl.4) |
|---|---|---|---|
| P,A | <u>EP - A2 - 0 151 811</u> (FUJITSU) <br><br> * Fig. 2-3; page 4, line 1 - page 5, line 1; page 10, line 1 - page 11, line 9; claim 5 * <br><br> -- | 1 | H 01 J 37/317 <br> H 01 J 37/147 |
| Y | <u>EP - A2 - 0 105 694</u> (TOKYO SHIBAURA) <br><br> * Fig. 1,10-11; page 5, line 32 - page 6, line 13; claim 1 * <br><br> -- | 1 | |
| Y | <u>FR - A1 - 2 488 043</u> (BUREVESTNIK) <br><br> * Fig.; page 5, line 9 - page 7, line 34 * | 1 | |
| A | * Page 5, lines 14-16 * <br><br> -- | 2 | **TECHNICAL FIELDS SEARCHED (Int. Cl.4)** |
| D,A | NUCLEAR INSTRUMENTS AND METHODS IN PHYSICS RESEARCH, 218, 1983 Amsterdam <br><br> T. ISHITANI "Mass-separated microbeam system with a liquid-metal-ion source" pages 363-367 <br><br> * Fig. 1,2; page 373, column 1 - column 2, line 13 * <br><br> -- | 1 | H 01 J 37/00 <br> H 01 J 3/00 <br> H 01 L 21/00 |
| A | <u>EP - A2 - 0 075 949</u> (HITACHI) <br><br> * Fig. 3; claims 1-4 * <br><br> ---- | 1 | |

The present search report has been drawn up for all claims

| Place of search | Date of completion of the search | Examiner |
|---|---|---|
| VIENNA | 20-12-1985 | BRUNNER |